# EUROPEAN PATENT APPLICATION

(11) **EP 4 164 362 A1**
(43) Date of publication of application: **12.04.2023**
(21) Application number: 22195909.1
(22) Date of filing: 15.09.2022
(51) Int. Cl.: H10K 77/10, H10K 102/00

(54) **ELECTRONIC DEVICE**

(30) Priority: 08.10.2021 CN 202111171407
(71) Applicant: InnoLux Corporation, Chu-Nan, Miao-Li 350 (TW)
(72) Inventor: WU, Yuan-Lin, 350 Miao-Li County (TW); LIN, Hsiu-Tung, 350 Miao-Li County (TW); CHENG, Pai-Chiao, 350 Miao-Li County (TW)
(74) Representative: 2K Patentanwälte Blasberg Kewitz & Reichel

(57) **Abstract**

An electronic device is provided. The electronic device includes a first inorganic insulating layer, a first substrate, a second inorganic insulating layer, and a plurality of electronic elements. The first substrate is disposed on the first inorganic insulating layer. The second inorganic insulating layer is disposed on the first substrate. The electronic elements are disposed on the second inorganic insulating layer. A thickness of the second inorganic insulating layer is less than a thickness of the first inorganic insulating layer.

## Description

### CROSS REFERENCE TO RELATED APPLICATIONS

This Application claims priority of China Patent Application No. 202111171407.7, filed on October 08, 2021, the entirety of which is incorporated by reference herein.

### BACKGROUND OF THE INVENTION

### Field of the Invention

The present disclosure relates to an electronic device, and more particularly, to an electronic device capable of blocking moisture better.

### Description of the Related Art

Electronic devices usually have metal wires to electrically connect different components. However, metal wires are vulnerable to moisture, which can cause the metal wires become oxidized or otherwise corroded. This may lead to adverse consequences such as poor conduction, short circuits, and leakage current in the electronic device.

In view of this, there is a need for a structure or device that is capable of reducing moisture damage to metal wires in electronic devices, so as to block moisture better and improve the aforementioned shortcomings.

### BRIEF SUMMARY OF THE INVENTION

An embodiment of the present disclosure provides an electronic device, including a first inorganic insulating layer, a first substrate, a second inorganic insulating layer, and a plurality of electronic elements. The first substrate is disposed on the first inorganic insulating layer. The second inorganic insulating layer is disposed on the first substrate. The electronic elements are disposed on the second inorganic insulating layer. A thickness of the second inorganic insulating layer is less than a thickness of the first inorganic insulating layer.

### BRIEF DESCRIPTION OF THE DRAWINGS

Various aspects disclosed in the present disclosure may be fully understood from the following detailed description in conjunction with the accompanying drawings. It should be noted that, in accordance with standard practice in the industry, the various features are not drawn to scale and are illustrative only. In fact, the dimensions of elements may be arbitrarily enlarged or reduced to clearly represent the features of the present disclosure.
FIG. 1 illustrates a cross-sectional view of an electronic device according to some embodiments of the present disclosure.
FIG. 2A illustrates a cross-sectional view of the electronic device according to some embodiments of the present disclosure.
FIG. 2B illustrates a cross-sectional view of the electronic device according to some embodiments of the present disclosure.
FIG. 2C illustrates a cross-sectional view of the electronic device according to some embodiments of the present disclosure.
FIG. 3 illustrates a top view of the electronic device according to some embodiments of the present disclosure.

### DETAILED DESCRIPTION OF THE INVENTION

The present disclosure may be more clearly understood by referring to the following description and the appended drawings. It should be noted that, for the sake of the simplicity of the drawings and comprehensibility for readers, only a portion of the light-emitting unit is illustrated in multiple figures in the present disclosure, and the specific components in the figures are not drawn to scale. In addition, the number and size of each component in the drawings merely serve as an example, and are not intended to limit the scope of the present disclosure. Furthermore, similar and/or corresponding numerals may be used in different embodiments for describing some embodiments simply and clearly, but they do not represent any relationship between different embodiments and/or structures discussed below.

Certain terms may be used throughout the present disclosure and the appended claims to refer to particular elements. Those skilled in the art will understand that electronic device manufacturers may refer to the same components by different names. The present specification is not intended to distinguish between components that have the same function but different names. In the following specification and claims, the words "including", "comprising", "having" and the like are open-ended words, so they should be interpreted as meaning "including but not limited to ..." Therefore, when the terms "including", "comprising", and/or "having" are used in the description of the disclosure, the presence of corresponding features, regions, steps, operations and/or components is specified without excluding the presence of one or more other features, regions, steps, operations and/or components.

In addition, in this specification, relative expressions may be used. For example, "lower", "bottom", "higher" or "top" are used to describe the position of one element relative to another. It should be noted that if a device is flipped upside down, an element that is "lower" will become an element that is "higher".

When a corresponding component (i.e. a film layer or region) is referred to as "on another component", it may be directly on another component, or there may be other components in between. On the other hand, when a component is referred "directly on another component", there is no component between the former two. In addition, when a component is referred "on another component", the two components have an up-down relationship in the top view, and this component can be above or below the other component, and this up-down relationship depends on the orientation of the device. Furthermore, the terms "electrically connected", "coupled" include any direct and indirect means of electrical connection. In addition, the terms such as "first" and "second" mentioned in this specification or the claims are only used to name different elements or to distinguish different embodiments or ranges, but not used to limit the upper limit or lower limit of the number of elements, and is not intended to limit the manufacturing order or the arrangement order of the elements.

The terms "about," "equal to," "equivalent," "the same as," "essentially," or "substantially" are generally interpreted as within 20% of a given value or range, or as interpreted as within 10%, 5%, 3%, 2%, 1%, or 0.5% of a given value or range.

It should be understood that, although the terms "first", "second" etc. may be used herein to describe various elements, layers and/or portions, and these elements, layers, and/or portions should not be limited by these terms. These terms are only used to distinguish one element, layer, or portion. Thus, a first element, layer or portion discussed below could be termed a second element, layer or portion without departing from the teachings of some embodiments of the present disclosure. In addition, for the sake of brevity, terms such as "first" and "second" may not be used in the description to distinguish different elements. As long as it does not depart from the scope defined by the appended claims, the first element and/or the second element described in the appended claims can be interpreted as any element that meets the description in the specification.

In the present disclosure, the thickness, length, and width can be measured by using an optical microscope, and the thickness can be measured by the cross-sectional image in the electron microscope, but it is not limited thereto. In addition, a certain error may be present in a comparison with any two values or directions. If the first value is equal to the second value, the deviation between the first value and the second value may be within about 10%. If the first direction is perpendicular to the second direction, the angle between the first direction and the second direction may be between 80 degrees and 100 degrees. If the first direction is parallel to the second direction, the angle between the first direction and the second direction may be between 0 degrees and 10 degrees.

As used herein, the terms "film" and/or "layer" may refer to any continuous or discontinuous structures and materials (such as materials deposited by the methods disclosed herein). For example, films and/or layers may include two-dimensional materials, three-dimensional materials, nanoparticles, or even partial or complete molecular layers, or partial or complete atomic layers, or clusters of atoms and/or molecules. The film or layer may comprise a material or layer having pinholes, which may be at least partially continuous.

As used herein, "structure" may include a substrate as described herein. The structure may include one or more layers overlying the substrate, such as one or more layers formed according to the methods described herein.

It should be noted that the technical solutions provided by different embodiments below may be interchangeable, combined or mixed to form another embodiment without departing from the spirit of the present disclosure.

Unless defined otherwise, all terms (including technical and scientific terms) used herein have the same meaning as commonly understood by one having ordinary skill in the art to which this disclosure belongs. It should be appreciated that, in each case, the term, which is defined in a commonly used dictionary, should be interpreted as having a meaning that conforms to the relative skills of the present disclosure and the background or the context of the present disclosure, and should not be interpreted in an idealized or overly formal manner unless so defined in the present disclosure.

The electronic device of the present disclosure may include, but is not limited to, a display device, an antenna device, a sensing device, a lighting device, or a splicing device. Electronic devices may include bendable or flexible electronic devices. Electronic devices may include electronic elements. The electronic device includes, for example, a liquid crystal layer or a light-emitting diode (LED). Electronic elements may include passive and active components, such as capacitors, resistors, inductors, diodes, transistors, inductors, and the like. The diodes may include light-emitting diodes or photodiodes. The light-emitting diodes may include, for example, organic light-emitting diodes (OLEDs), sub-millimeter light-emitting diodes (mini LEDs), micro light-emitting diodes (micro LEDs), quantum dot light-emitting diodes (quantum dot LED), fluorescence, phosphor, or other suitable materials, or combinations thereof, but not limited thereto. Sensors may include, for example, capacitive sensors, optical sensors, electromagnetic sensors, fingerprint sensors (FPS), touch sensors, antenna, or pen sensor, etc., but not limited to. Hereinafter, the present disclosure will be described by taking the display device as the electronic device, but the present disclosure is not limited thereto.

The display device of the present disclosure may be a self-luminous display device, such as an organic light-emitting diode display device, but not limited thereto. Hereinafter, the present disclosure will be described by taking the display device as the electronic device, but the present disclosure is not limited thereto.

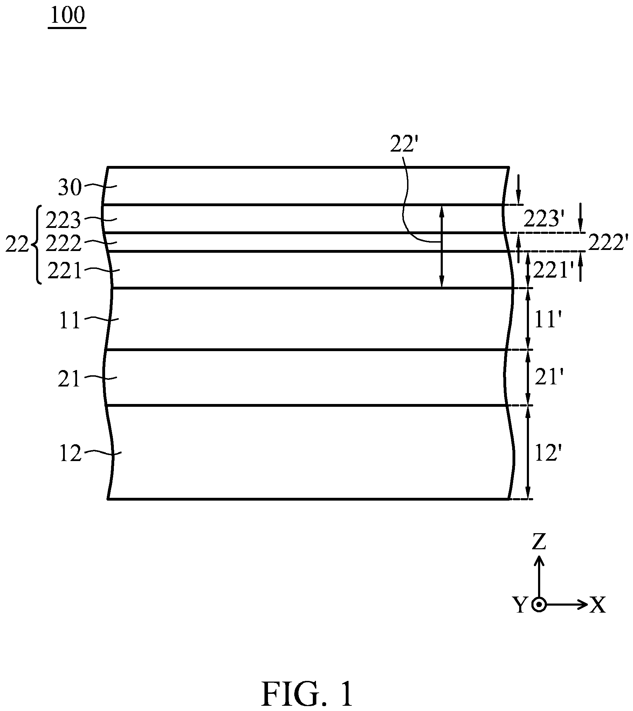

Now referring to the drawings, FIG. 1 illustrates a cross-sectional view of an electronic device 100 according to some embodiments of the present disclosure. The electronic device 100 may include a first inorganic insulating layer 21, a first substrate 11, an insulating layer 22, and an electronic element structure 30 (including a plurality of electronic elements, not shown). In some embodiments, the first substrate 11 may be disposed on the first inorganic insulating layer 21, and the insulating layer 22 may be disposed on the first substrate 11. The electronic element structure 30 may be disposed on the insulating layer 22.

In some embodiments, the electronic device 100 may further include a second substrate 12 disposed under the first inorganic insulating layer 21, and thus the first inorganic insulating layer 21 may be disposed between the first substrate 11 and the second substrate 12. In some embodiments, the first substrate 11 and the second substrate 12 may be defined by materials. For example, in some embodiments, the first substrate 11 and the second substrate 12 may include organic materials, such as high molecular polymers, etc., but not limited thereto. For example, in some embodiments, the first substrate 11 and the second substrate 12 may include polyimide, but not limited thereto.

In some embodiments, the first substrate 11 and the second substrate 12 may also be defined by Young's modulus. In some embodiments, the Young's modulus of the first substrate 11 and the second substrate 12 may be between 30 megapascals (MPa) and 4500 megapascals. In some embodiments, the Young's modulus of the first substrate 11 and the second substrate 12 may be between 30 MPa and 40 MPa. In some embodiments, the Young's modulus of the first substrate 11 and the second substrate 12 may be about 30 megapascals. In some embodiments, the Young's modulus of the first substrate 11 and the second substrate 12 may be about 34 MPa, but not limited thereto.

In some embodiments, the Young's modulus of the first substrate 11 and the second substrate 12 may be about 4100 megapascals. In some embodiments, the electronic device 100 may further include a support film (which may include polyethylene terephthalate (PET), not shown in the figures) disposed under the second substrate 12, and the Young's modulus of the structure of the substrate 12 and its underlying support film may be about 4100 megapascals.

In some embodiments, the first substrate 11 and the second substrate 12 may be defined by their thicknesses. For example, in some embodiments, the thickness of the first substrate 11 and/or the thickness of the second substrate 12 may be greater than the respective thicknesses of the first inorganic insulating layer 21 or the insulating layer 22. For example, in some embodiments, the thickness of the first substrate 11 and/or the thickness of the second substrate 12 may be about 10 times greater than the respective thickness of the first inorganic insulating layer 21 or the insulating layer 22, but not limited thereto.

The first inorganic insulating layer 21 and the insulating layer 22 may have materials that reduce moisture penetration.

In some embodiments, since the electronic element structure 30 is disposed on the insulating layer 22, the insulating layer 22 may be disposed between the electronic element structure 30 and the first substrate 11. In this way, the insulating layer 22 may reduce the moisture transmitted from the first substrate 11 to the electronic device structure 30, thereby reducing the probability of the electronic device structure 30 being corroded or damaged due to being in contact with the moisture.

In some embodiments, the first inorganic insulating layer 21 may be disposed between the first substrate 11 and the second substrate 12. In this way, the first inorganic insulating layer 21 may reduce the moisture transmitted from the second substrate 12 to the first substrate 11 (or the electronic device structure 30), thereby reducing the probability of the electronic device structure 30 being corroded or damaged due to being in contact with the moisture.

The first inorganic insulating layer 21 may include a single-layer or multi-layer structure. The insulating layer 22 may include a single layer or a multi-layer structure. When the insulating layer 22 is, for example, a multi-layer structure, it may include a second inorganic insulating layer 221, a third inorganic insulating layer 222, and a fourth inorganic insulating layer 223.

In some embodiments, the materials of the first inorganic insulating layer 21, the second inorganic insulating layer 221, and the fourth inorganic insulating layer 223 may be the same, and the materials of the first inorganic insulating layer 21, the second inorganic insulating layer 221, and the fourth inorganic insulating layer 223 may be different from the material of the third inorganic insulating layer 222.

In some embodiments, the proportion of oxygen (O) contained in the first inorganic insulating layer 21, the second inorganic insulating layer 221, or the fourth inorganic insulating layer 223 may be higher than the proportion of oxygen contained in the third inorganic insulating layer 222. In some embodiments, the proportion of nitrogen (N) contained in the third inorganic insulating layer 222 may be higher than the proportion of nitrogen contained in the first inorganic insulating layer 21, the second inorganic insulating layer 221, or the fourth inorganic insulating layer 223. For example, the first inorganic insulating layer 21, the second inorganic insulating layer 221, and the fourth inorganic insulating layer 223 may include silicon oxide (SiOₓ), and the third inorganic insulating layer 222 may include silicon nitride (SiN_{y}).

In some embodiments, the first inorganic insulating layer 21, the second inorganic insulating layer 221, the third inorganic insulating layer 222, and the fourth inorganic insulating layer 223 may include silicon oxynitride (SiOₓN_{y}), while the nitrogen-oxygen ratio of the silicon oxynitride (SiOₓ₁N_{y1}) contained by the first inorganic insulating layer 21, the second inorganic insulating layer 221, and the fourth inorganic insulating layer 223 may be different from the nitrogen-oxygen ratio of the silicon oxynitride (SiOₓ₂N_{y2}) contained by the third inorganic insulating layer 222 (i.e., x1 is not equal to x2, or y1 is not equal to y2). In some embodiments, x1 may be greater than x2, and y2 may be greater than y1.

Referring to FIG. 1, the second inorganic insulating layer 221, the third inorganic insulating layer 222, and the fourth inorganic insulating layer 223 are disposed between the electronic element structure 30 and the first substrate 11, this may reduce the moisture transmitted from the first substrate 11.

In some embodiments, the second inorganic insulating layer 221 is disposed on the first substrate 11. In some embodiments, the third inorganic insulating layer 222 is disposed on the second inorganic insulating layer 221. In some embodiments, the fourth inorganic insulating layer 223 is disposed on the third inorganic insulating layer 222. In some embodiments, the electronic element structure 30 is disposed on the fourth inorganic insulating layer 223.

That is, in some embodiments, the fourth inorganic insulating layer 223 is disposed between the electronic element structure 30 and the third inorganic insulating layer 222. In some embodiments, the third inorganic insulating layer 222 is disposed between the fourth inorganic insulating layer 223 and the second inorganic insulating layer 221.

With this configuration, an interface with different materials may be generated in the insulating layer 22 (the interface between the second inorganic insulating layer 221 and the third inorganic insulating layer 222, and the interface between the third inorganic insulating layer 222 and the fourth inorganic insulating layer 223), so that the transmission path of the moisture transmitted from the first substrate 11 to the electronic element structure 30 has to pass through several interfaces, and the length of the transmission path of the moisture may be increased, and thus the moisture transmitted to the electronic element structure 30 may be reduced.

In some embodiments, the thicknesses of the first inorganic insulating layer 21, the second inorganic insulating layer 221, the third inorganic insulating layer 222, and the fourth inorganic insulating layer 223 may be different from each other. It should be noted that the so-called thickness here may be the thickness along the arrangement direction of each layer, or the thickness along the direction from the first substrate 11 or the second substrate 12 to the electronic element structure 30 (that is, the normal direction of the first substrate 11 or the second substrate 12), for example, the Z direction. For example, in the embodiment shown in FIG. 1, the thickness of each layer is parallel to the Z direction.

The first inorganic insulating layer 21 may have a first thickness 21', the second inorganic insulating layer 221 may have a second thickness 221', the third inorganic insulating layer 222 may have a third thickness 222', and the fourth inorganic insulating layer 223 may have a fourth thickness 223'.

In some embodiments, the first thickness 21' may be greater than the second thickness 221', the third thickness 222', and the fourth thickness 223'. In this way, the path length of the moisture penetration may be increased, so that the first inorganic insulating layer 21 may reduce the moisture transmitted from the second substrate 12.

In some embodiments, the second thickness 221' may be greater than the third thickness 222' and the fourth thickness 223'. In this way, the path length of the moisture penetration may be increased, so that the second inorganic insulating layer 221 may reduce the moisture transmitted from the first substrate 11. Furthermore, since the fourth thickness 223' is smaller, the fourth inorganic insulating layer 223 may be made denser than the second inorganic insulating layer 221 (for example, the fourth inorganic insulating layer 223 may have fewer holes and/or cracks), the number of paths through which the moisture penetrates is reduced, so that the fourth inorganic insulating layer 223 may reduce the moisture transmitted from the first substrate 11. In addition, since the fourth thickness 223' is smaller, the internal stress of the fourth inorganic insulating layer 223 is less likely to affect its adhesion to other elements, so that the adhesion of the fourth inorganic insulating layer 223 to other elements (for example, the third inorganic insulating layer 222 and/or the electronic device structure 30) may be improved.

In some embodiments, the fourth thickness 223' may be greater than the third thickness 222'. Likewise, due to higher proportion of nitrogen contained in the third inorganic insulating layer 222, its internal stress may be greater than that of other inorganic insulating layers. Therefore, in the case that the third thickness 222' is smaller, the internal stress of the third inorganic insulating layer 222 may be reduced, and the third inorganic insulating layer 222 may be made denser, and the third inorganic insulating layer 222 may reduce the moisture transmitted from the first substrate 11. Furthermore, in the case where the third thickness 222' is smaller, the adhesion of the third inorganic insulating layer 222 to other elements (e.g., the second inorganic insulating layer 221 and/or the fourth inorganic insulating layer 223) may be improved.

In some embodiments, the first substrate 11 may have a first substrate thickness 11', and the second substrate 12 may have a second substrate thickness 12'. The first substrate thickness 11' and the second substrate thickness 12' are thicker than that of the insulating layer, so that the first substrate 11 and the second substrate 12 may have higher strength to carry different layers, elements, structures, or devices.

In some embodiments, the thickness of the first substrate 11 is less than the thickness of the second substrate 12 (i.e., the first substrate thickness 11' is less than the second substrate thickness 12'). In this way, the moisture contained in the first substrate 11 may be reduced, and the moisture transmitted from the first substrate 11 to the electronic device structure 30 may be reduced. In some embodiments, the difference between the thickness of the second substrate 12 and the thickness of the first substrate 11 (i.e., the second substrate thickness 12' minus the first substrate thickness 11') may be greater than or equal to 0.1 micrometer and less than or equal to 6 micrometer.

When the difference between the thickness of the second substrate 12 and the thickness of the first substrate 11 is less than 0.1 micrometer, the thickness of the first substrate 11 will increase and be close to the thickness of the second substrate 12, and the first substrate 11 will contains more moisture, which will increase the moisture transmitted from the first substrate 11 to the electronic device structure 30, this is harmful to the electronic device structure 30.

When the difference between the thickness of the second substrate 12 and the thickness of the first substrate 11 is greater than 6 micrometer, the first substrate 11 and the second substrate 12 are likely to be warped, so that the first inorganic insulating layer 21 between the first substrate 11 and the second substrate 12 is prone to generate more cracks and paths for moisture transmission, which increases the probability of moisture penetrated through the first inorganic insulating layer 21, which is harmful to the electronic device structure 30.

When the difference between the thickness of the second substrate 12 and the thickness of the first substrate 11 is within the aforementioned range, the first substrate 11 and the second substrate 12 may reduce the moisture transmitted to the electronic device structure 30.

According to some embodiments, the values of the first thickness 21', the second thickness 221', the third thickness 222', the fourth thickness 223', the first substrate thickness 11', and the second substrate thickness 12' may be shown in the Table 1.1 and Table 1.2.

**Table 1.1**

| | Embodiment 1 | Embodiment 2 | Embodiment 3 |
|---|---|---|---|
| Fourth thickness 223' (micrometer) | 0.29 | 0.29 | 0.28 |
| Third Thickness 222' (micrometer) | 0.06 | 0.06 | 0.06 |
| Second Thickness 221' (micrometer) | 0.55 | 0.54 | 0.52 |
| First substrate thickness 11' (micrometer) | 9.01 | 5.16 | 5.22 |
| First thickness 21' (micrometer) | 0.57 | 0.65 | 0.69 |
| Second substrate thickness 12' (micrometer) | 9.35 | 5.54 | 9.68 |

**Table 1.2**

| | Embodiment 4 | Embodiment 5 | Embodiment 6 |
|---|---|---|---|
| Fourth thickness 223' (micrometer) | 0.31 | 0.32 | 0.30 |
| Third Thickness 222' (micrometer) | 0.06 | 0.06 | 0.07 |
| Second Thickness 221' (micrometer) | 0.53 | 0.53 | 0.52 |
| First substrate thickness 11' (micrometer) | 5.11 | 5.13 | 5.06 |
| First thickness 21' (micrometer) | 0.60 | 0.62 | 0.60 |
| Second substrate thickness 12' (micrometer) | 9.62 | 9.03 | 9.33 |

It should be noted that the numerical values listed in Table 1.1 and Table 1.2 above are only examples and should not be regarded as limiting the present disclosure.

In some embodiments, the insulating layer 22 may have a total thickness 22'. In some embodiments, as shown in FIG. 1, the total thickness 22' may be the sum of the second thickness 221', the third thickness 222', and the fourth thickness 223'. In some embodiments, the total thickness 22' may be greater than the first thickness 21' so that the insulating layer 22 may reduce the moisture transmitted from the first substrate 11.

In some embodiments, the ratio of the first thickness 21' to the total thickness 22' (the first thickness 21' / the total thickness 22') may be greater than or equal to 0.4 and less than or equal to 0.95. In some embodiments, the ratio of the first thickness 21' to the total thickness 22' (the first thickness 21' / the total thickness 22') may preferably be greater than or equal to 0.6 and less than or equal to 0.8.

When the ratio of the first thickness 21' to the total thickness 22' is less than the aforementioned range (e.g., less than 0.4), the effect of blocking moisture of the first inorganic insulating layer 21 may be reduced.

When the ratio of the first thickness 21' to the total thickness 22' is greater than the aforementioned range (e.g., greater than 0.95), the first inorganic insulating layer 21 may be easily separated from the second substrate 12, or the first inorganic insulating layer 21 may be easily separated from the first substrate 11.

When the ratio of the first thickness 21' to the total thickness 22' is within the aforementioned range (e.g., greater than or equal to 0.4 and less than or equal to 0.95), the first inorganic insulating layer 21 may reduce the moisture transmitted from the second substrate 12, and the adhesion of the first inorganic insulating layer 21 to other elements (e.g., the first substrate 11 and/or the second substrate 12) may be improved.

As previously mentioned, the first substrate thickness 11' and the second substrate thickness 12' may be different. In some embodiments, the ratio of the first substrate thickness 11' to the second substrate thickness 12' (the first substrate thickness 11' / the second substrate thickness 12') may be greater than or equal to 0.5 and less than 1.

When the ratio of the first substrate thickness 11' to the second substrate thickness 12' (the first substrate thickness 11' / the second substrate thickness 12') is less than 0.5, the first substrate 11 and the second substrate 12 will easily warp, so that the first inorganic insulating layer 21 disposed between the first substrate 11 and the second substrate 12 is prone to generate more cracks and paths for moisture transmission, and the moisture penetrated through the first inorganic insulating layer 21 is reduced.

When the ratio of the first substrate thickness 11' to the second substrate thickness 12' (the first substrate thickness 11' / the second substrate thickness 12') is greater than or equal to 1, the first substrate 11 will contain more moisture, and the moisture transmitted from the first substrate 11 to the electronic device structure 30 will increase, which will be harmful to the electronic device structure 30.

When the ratio of the first substrate thickness 11' to the second substrate thickness 12' (the first substrate thickness 11'/ the second substrate thickness 12') is within the aforementioned range, the first substrate 11 and the second substrate 12 may reduce the moisture transmitted to the electronic element structure 30.

As mentioned above, the first thickness 21', the second thickness 221', and the fourth thickness 223' may be different. In some embodiments, the ratio of the second thickness 221' to the first thickness 21' (the second thickness 221' / the first thickness 21') may be greater than or equal to 0.7 and less than 1. In some embodiments, the ratio of the fourth thickness 223' to the second thickness 221' (the fourth thickness 223' / the second thickness 221') may be greater than or equal to 0.4 and less than or equal to 0.8. In some embodiments, the ratio of the fourth thickness 223' to the sum of the first thickness 21', the second thickness 221', and the fourth thickness 223' (the fourth thickness 223' / (the first thickness 21' + the second thickness 221' + the fourth thickness 223')) may be greater than or equal to 0.1 and less than or equal to 0.3.

That is, the thicknesses of the first inorganic insulating layer 21, the second inorganic insulating layer 221, and the fourth inorganic insulating layer 223 is smaller if it is closer to the electronic device structure 30 (refer to FIG. 1). In this way, the internal stress of the insulating layer closer to the electronic device structure 30 may be smaller, and the holes thereof may be less (more dense), so as to reduce the moisture transmission path and reduce the moisture transmission.

In some embodiments, the ratio of the sum of the first thickness 21', the second thickness 221', the third thickness 222' and the fourth thickness 223' to the sum of the first substrate thickness 11' and the second substrate thickness 12' ((the first thickness 21' + the second thickness 221' + the third thickness 222' + the fourth thickness 223') / (the first substrate thickness 11' + the second substrate thickness 12')) may be greater than or equal to 0.05 and less than or equal to 0.2.

When the ratio of the sum of the first thickness 21', the second thickness 221', the third thickness 222', and the fourth thickness 223' to the sum of the first substrate thickness 11' and the second substrate thickness 12' ((the first thickness 21' + the second thickness 221' + the third thickness 222' + the fourth thickness 223') / (the first substrate thickness 11' + the second substrate thickness 12')) is less than 0.05, the moisture will easily penetrate the first inorganic insulating layer 21, the second inorganic insulating layer 221, the third inorganic insulating layer 222, and the fourth inorganic insulating layer 223.

When the ratio of the sum of the first thickness 21', the second thickness 221', the third thickness 222', and the fourth thickness 223' to the sum of the first substrate thickness 11' and the second substrate thickness 12' ((the first thickness 21' + the second thickness 221' + the third thickness 222' + the fourth thickness 223') / (the first substrate thickness 11' + the second substrate thickness 12')) is greater than 0.2, the tack time for manufacturing the electronic device 100 will be increased, which is not helpful to the manufacturing process and/or the cost of the electronic device 100. Furthermore, the first inorganic insulating layer 21, the second inorganic insulating layer 221, the third inorganic insulating layer 222, and the fourth inorganic insulating layer 223 are prone to generate more holes, so that the moisture may penetrate more easily.

When the ratio of the sum of the first thickness 21', the second thickness 221', the third thickness 222', and the fourth thickness 223' to the sum of the first substrate thickness 11' and the second substrate thickness 12' ((the first thickness 21' + the second thickness 221' + the third thickness 222' + the fourth thickness 223') / (the first substrate thickness 11' + the second substrate thickness 12')) is within the aforementioned range, the internal stress of each layer may be smaller, and less holes are generated (more dense) to reduce the moisture transmission path and reduce the moisture transmission.

In some embodiments, the ratio of the sum of the first thickness 21', the second thickness 221', and the fourth thickness 223' to the sum of the first substrate thickness 11' and the second substrate thickness 12' ((the first thickness 21' + the second thickness 221' + the fourth thickness 223') / (the first substrate thickness 11'+ the second substrate thickness 12')) may be greater than or equal to 0.05 and less than or equal to 0.2.

When the ratio of the sum of the first thickness 21', the second thickness 221', and the fourth thickness 223' to the sum of the first substrate thickness 11' and the second substrate thickness 12' ((the first thickness 21' + the second thickness 221' + the fourth thickness 223') / (the first substrate thickness 11'+ the second substrate thickness 12')) is less than 0.05, the moisture will easily penetrate through the first inorganic insulating layer 21, the second inorganic insulating layer 221 and the fourth inorganic insulating layer 223.

When the ratio of the sum of the first thickness 21', the second thickness 221', and the fourth thickness 223' to the sum of the first substrate thickness 11' and the second substrate thickness 12' ((the first thickness 21' + the second thickness 221' + the fourth thickness 223') / (the first substrate thickness 11'+ the second substrate thickness 12')) is greater than 0.2, the tack time for manufacturing the electronic device 100 will be increased, which is not helpful to the manufacturing process and/or the cost of the electronic device 100. Furthermore, the first inorganic insulating layer 21, the second inorganic insulating layer 221, and the fourth inorganic insulating layer 223 are prone to generate more holes, so that the moisture may penetrate more easily.

When the ratio of the sum of the first thickness 21', the second thickness 221', and the fourth thickness 223' to the sum of the first substrate thickness 11' and the second substrate thickness 12' ((the first thickness 21' + the second thickness 221' + the fourth thickness 223') / (the first substrate thickness 11'+ the second substrate thickness 12')) is within the aforementioned range, the internal stress of each layer may be smaller, and less holes are generated (more dense) to reduce the moisture transmission path and reduce the moisture transmission.

According to some embodiments (refer to the numerical values in Table 1.1 and Table 1.2), the ratio relationship of the thickness of each layer may be as shown in Table 2.1 and Table 2.2.

**Table 2.1**

| | Embodiment 1 | Embodiment 2 | Embodiment 3 |
|---|---|---|---|
| First thickness 21' / total thickness 22' | 0.64 | 0.72 | 0.80 |
| First substrate thickness 11'/ second substrate thickness 12' | 0.96 | 0.93 | 0.54 |
| Second thickness 221' / first thickness 21' | 0.96 | 0.84 | 0.76 |
| Fourth thickness 223' / second thickness 221' | 0.53 | 0.54 | 0.53 |
| Fourth thickness 223' / (first thickness 21' + second thickness 221' + fourth thickness 223') | 0.21 | 0.20 | 0.19 |
| (First thickness 21' + second thickness 221' + third thickness 222' + fourth thickness 223') / (first substrate thickness 11' + second substrate thickness 12') | 0.080 | 0.145 | 0.104 |

**Table 2.2**

| | Embodiment 4 | Embodiment 5 | Embodiment 6 |
|---|---|---|---|
| First thickness 21' / total thickness 22' | 0.67 | 0.68 | 0.68 |
| First substrate thickness 11' / second substrate thickness 12' | 0.53 | 0.57 | 0.54 |
| Second thickness 221' / first thickness 21' | 0.88 | 0.86 | 0.86 |
| Fourth thickness 223' / second thickness 221' | 0.59 | 0.60 | 0.59 |
| Fourth thickness 223' / (first thickness 21' + second thickness 221' + fourth thickness 223') | 0.22 | 0.22 | 0.21 |
| (First thickness 21' + second thickness 221' + third thickness 222' + fourth thickness 223') / (first substrate thickness 11' + second substrate thickness 12') | 0.102 | 0.108 | 0.103 |

It should be noted that the numerical values listed in Table 2.1 and Table 2.2 above are only examples and should not be regarded as limiting the present disclosure.

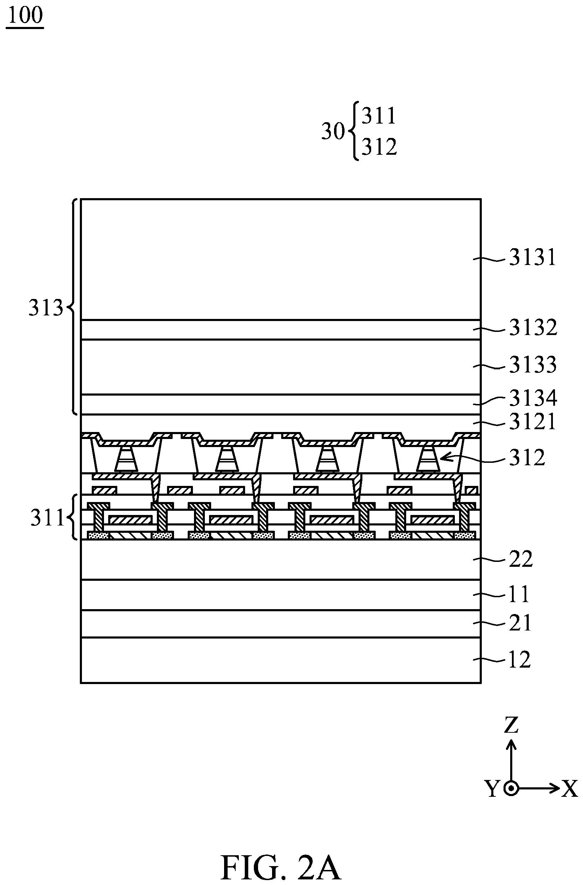

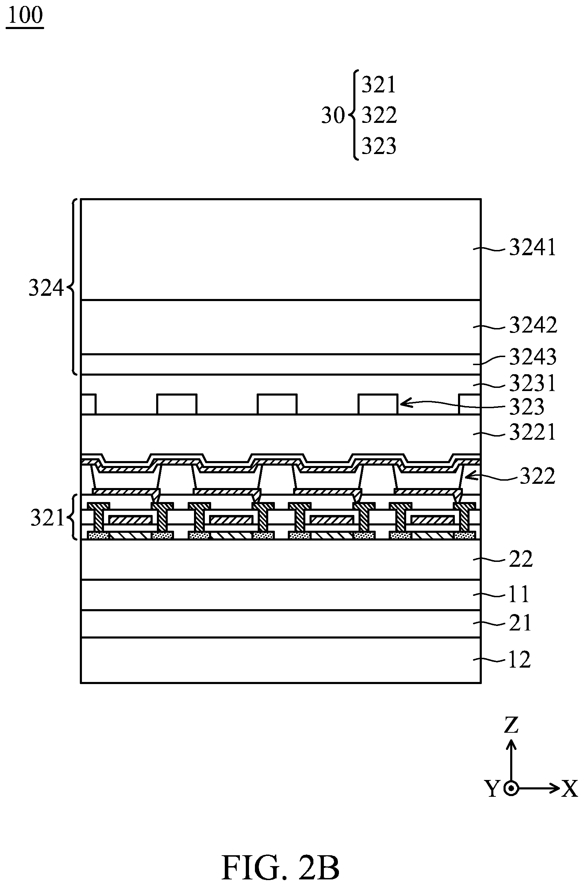

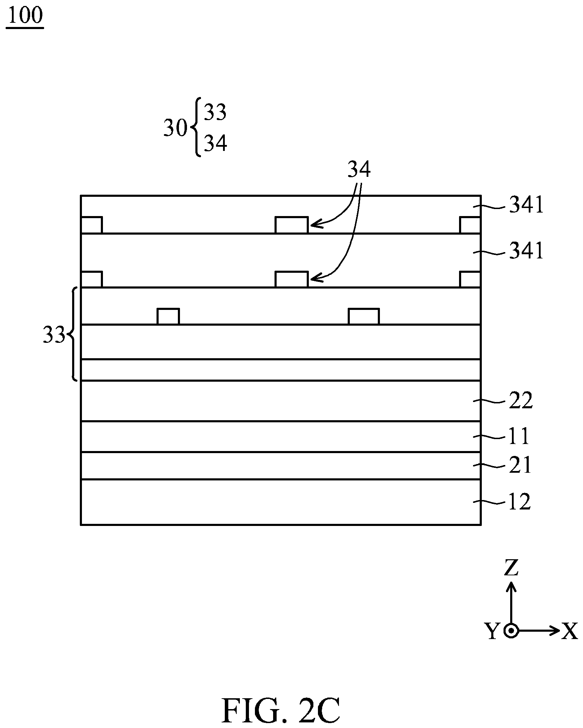

Please refer to FIG. 2A, FIG. 2B and FIG. 2C. In some embodiments, the electronic element structure 30 may include a plurality of electronic elements (e.g., including display elements and/or sensors, etc.), circuit structures, and the like.

As shown in FIG. 2A, FIG. 2A illustrates a cross-sectional view of an electronic device 100 according to some embodiments of the present disclosure. In the embodiment of FIG. 2A, the electronic element structure 30 may include a circuit structure 311 and a plurality of electronic elements 312, and a cover 313 is on the electronic element structure 30, wherein the electronic element 312 may be, for example, a display element (such as micro-light-emitting diodes), but not limited thereto. The cover 313 may include a protective layer 3131, an adhesive layer 3132, an anti-reflection layer 3133 and an adhesive layer 3134, but not limited thereto.

In one embodiment, the circuit structure 311 may be disposed on the insulating layer 22, and the circuit structure 311 may include a conductive layer and an insulating layer. In one embodiment, the conductive layer in the circuit structure 311 may be made of metal, so the probability of the circuit structure 311 being exposed to the moisture must be reduced.

In one embodiment, the electronic elements 312 may be disposed on the circuit structure 311. In one embodiment, an encapsulation layer 3121 may be disposed on the electronic element 312. In one embodiment, the cover 313 may be disposed on the electronic element 312 and located on top of the electronic device 100. The cover 313 may reduce the moisture transmitted from the top of the electronic device 100 to reduce the probability of the electronic element structure 30 being damaged by the moisture.

As shown in FIG. 2B, FIG. 2B illustrates a cross-sectional view of an electronic device 100 according to some embodiments of the present disclosure. In the embodiment of FIG. 2B, the electronic element structure 30 may include a circuit structure 321, a plurality of electronic elements (including a plurality of display elements 322 and a plurality of sensors 323), and a cover 324 is disposed on the electronic element structure 30, wherein the display element 322 may be, for example, an organic light-emitting diode, but not limited thereto. The cover 324 may include a protective layer 3241, an anti-reflection layer 3242 and an adhesive layer 3243, but not limited thereto.

As mentioned above, the circuit structure 321 includes a conductive layer and an insulating layer, and the conductive layer may be made of metal. Therefore, it is necessary to reduce the probability of the circuit structure 321 being exposed to the moisture. In this embodiment, the Young's modulus of the overall structure of the second substrate 12, the first inorganic insulating layer 21, the first substrate 11, the insulating layer 22, the circuit structure 321 and the display element 322 is about 4100 MPa, but not limited to thereto.

In one embodiment, the display element 322 may be disposed on the circuit structure 321. In one embodiment, an encapsulation layer 3221 may be further disposed on the display element 322. In one embodiment, the sensor 323 may be disposed on the display element 322, but not limited thereto. In one embodiment, the insulating layer 3231 may be further disposed on the inductor 323. In one embodiment, the cover 324 may be disposed on the sensor 323 and located on the top of the electronic device 100. The cover 324 may effectively block the moisture transmitted from the top of the electronic device 100 to prevent the electronic element structure 30 from being damaged by the moisture. The sensor 323 may be as described above and will not be repeated here.

As shown in FIG. 2C, FIG. 2C illustrates a cross-sectional view of an electronic device 100 according to some embodiments of the present disclosure. In the embodiment of FIG. 2C, the electronic element structure 30 may include a circuit structure 33 and a plurality of electronic elements (including a plurality of sensors 34). The sensor 34 may be as described above and will not be repeated here.

In one embodiment, the circuit structure 33 may be disposed on the insulating layer 22. As mentioned above, the circuit structure 33 includes a conductive layer and an insulating layer, and the conductive layer may be made of metal. Therefore, it is necessary to reduce the probability of the circuit structure 33 being exposed to the moisture. In one embodiment, an inductor 34 may be disposed on the circuit structure 33. In one embodiment, an insulating layer 341 may be further disposed on the inductor 34.

It should be noted that the above listed embodiments are only examples and should not be regarded as limiting the present disclosure.

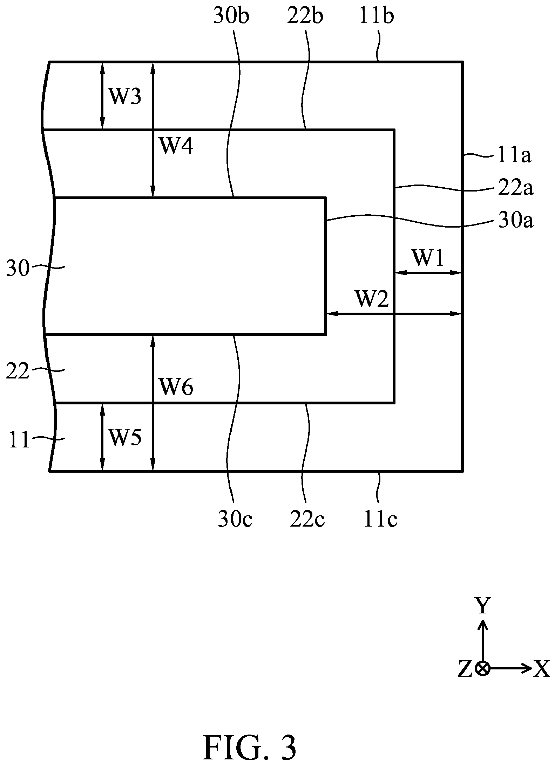

Please refer to FIG. 3, FIG. 3 illustrates a top view of an electronic device 100 according to some embodiments of the present disclosure. The first substrate 11 may have a boundary 11a, a boundary 11b, and a boundary 11c. The insulating layer 22 may have a boundary 22a, a boundary 22b, and a boundary 22c. The circuit structure in the electronic element structure 30 (as the circuit structure 311 in shown FIG. 2A, or the circuit structure 321 shown in FIG. 2B, or the circuit structure 33 shown in FIG. 2C) may have a boundary 30a, a boundary 30b, and a boundary 30c.

As shown in FIG. 3, the boundary 11a, the boundary 22a, and the boundary 30a correspond to each other; the boundary 11b, the boundary 22b, and the boundary 30b correspond to each other; and the boundary 11c, the boundary 22c, and the boundary 30c correspond to each other.

There is a distance W1 between the boundary 11a and the boundary 22a; there is a distance W2 between the boundary 11a and the boundary 30a; there is a distance W3 between the boundary 11b and boundary 22b; there is a distance W4 between the boundary 11b and the boundary 30b; there is a distance W5 between the boundary 11c and the boundary 22c; and there is a distance W6 between the boundary 11c and the boundary 30c.

In one embodiment, the distance W1, the distance W3, and the distance W5 may be greater than or equal to 0 and less than or equal to 1 micrometer. In one embodiment, the distance W1, the distance W3, and the distance W5 may be the same. In one embodiment, the distance W1, the distance W3 and the distance W5 may be different.

In one embodiment, the distance W2, the distance W4 and the distance W6 may be greater than the distance W1, the distance W3 and the distance W5. In one embodiment, distance W2, distance W4, and distance W6 may be greater than or equal to 100 microns and less than or equal to 10,000 microns. In one embodiment, the distance W2, the distance W4, and the distance W6 may be the same. In one embodiment, distance W2, distance W4, and distance W6 may be different.

That is, the insulating layer 22 may extend beyond the electronic element structure 30, and the first substrate 11 may extend beyond the insulating layer 22. Therefore, the insulating layer 22 partially overlaps the first substrate 11, and the electronic element structure 30 partially overlaps the insulating layer 22. In this way, the edges of the electronic element structure 30 may be avoided from moisture.

It should be noted that the shape shown in FIG. 3 is only an example, and should not be regarded as limiting the present disclosure.

In conclusion, the embodiment of the present disclosure may reduce the damage of the electronic device 100 (especially for the electronic element structure 30) by moisture, so as to improve the reliability and/or lifespan of the electronic device 100, and the electronic device 100 of the embodiment of the present disclosure may also have advantages in manufacture and cost reduction.

While the embodiments and the advantages of the present disclosure have been described above, it should be understood that those skilled in the art may make various changes, substitutions, and alterations to the present disclosure without departing from the spirit and scope of the present disclosure. It should be noted that different embodiments may be arbitrarily combined as other embodiments as long as the combination conforms to the spirit of the present disclosure. In addition, the scope of the present disclosure is not limited to the processes, machines, manufacture, composition, devices, methods and steps in the specific embodiments described in the specification. Those skilled in the art may understand existing or developing processes, machines, manufacture, compositions, devices, methods and steps from some embodiments of the present disclosure. Therefore, the scope of the present disclosure includes the aforementioned processes, machines, manufacture, composition, devices, methods, and steps. Furthermore, each of the appended claims constructs an individual embodiment, and the scope of the present disclosure also includes every combination of the appended claims and embodiments.

## Claims

1. An electronic device (100), comprising:
a first inorganic insulating layer (21);
a first substrate (11), disposed on the first inorganic insulating layer;
a second inorganic insulating layer (221), disposed on the first substrate; and
a plurality of electronic elements (30), disposed on the second inorganic insulating layer;
wherein a thickness of the second inorganic insulating layer is less than a thickness of the first inorganic insulating layer.

2. The electronic device of claim 1, wherein the second inorganic insulating layer and the first inorganic insulating layer comprise the same material.

3. The electronic device of claim 1 or 2, further comprising a third inorganic insulating layer disposed between the second inorganic insulating layer and the electronic elements,
wherein a thickness of the third inorganic insulating layer is less than the thickness of the second inorganic insulating layer.

4. The electronic device of claim 3, wherein the third inorganic insulating layer and the second inorganic insulating layer comprise different materials.

5. The electronic device of claim 3 or 4, further comprising a fourth inorganic insulating layer (223) disposed between the third inorganic insulating layer and the electronic elements,
wherein a thickness of the fourth inorganic insulating layer is greater than the thickness of the third inorganic insulating layer.

6. The electronic device of claim 5, wherein the thickness of the fourth inorganic insulating layer is less than the thickness of the second inorganic insulating layer.

7. The electronic device of claim 5 or 6, wherein the fourth inorganic insulating layer and the second inorganic insulating layer comprise the same material.

8. The electronic device of any of the claims 5 to 7, wherein the first inorganic insulating layer has a first thickness, the second inorganic insulating layer has a second thickness, the third inorganic insulating layer has a third thickness, and the fourth inorganic insulating layer has a fourth thickness,
wherein the first thickness is less than a total thickness, and the total thickness is the sum of the second thickness, the third thickness and the fourth thickness.

9. The electronic device of claim 8, wherein:
a ratio of the first thickness to the total thickness is greater than or equal to 0.4 and less than or equal to 0.95;
and/or
a ratio of the second thickness to the first thickness is greater than or equal to 0.7 and less than 1;
and/or
wherein a ratio of the fourth thickness to the first thickness is greater than or equal to 0.4 and less than or equal to 0.8;
and/or
wherein a ratio of the fourth thickness to the sum of the first thickness, the second thickness and the fourth thickness is greater than or equal to 0.1 and less than or equal to 0.3.

10. The electronic device of any of the claims 1 to 9, further comprising a second substrate, wherein the first inorganic insulating layer is disposed between the first substrate and the second substrate.

11. The electronic device of claim 10, wherein the first substrate and the second substrate comprise organic materials.

12. The electronic device of claim 10 or 11,
wherein a thickness of the first substrate is less than a thickness of the second substrate;
and/or
wherein a ratio of a thickness of the first substrate to a thickness of the second substrate is greater than or equal to 0.5 and less than 1;
and/or
wherein a difference between a thickness of the second substrate and a thickness of the first substrate is greater than or equal to 0.1 micrometers and less than or equal to 6 micrometers;
and/or
wherein a ratio of a first substrate thickness of the first substrate to a second substrate thickness of the second substrate is greater than or equal to 0.5 and less than 1.

13. The electronic device of any of the claims 1 to 12, wherein the electronic elements comprise organic light-emitting diodes, sub-millimeter light-emitting diodes, or micro-light-emitting diodes.

14. The electronic device of any of the claims 1 to 13, wherein the electronic elements comprise capacitive sensors, optical sensors, or electromagnetic sensors.
